# EUROPEAN PATENT APPLICATION

(11) **EP 3 786 134 A1**
(43) Date of publication of application: **03.03.2021**
(21) Application number: 19792538.1
(22) Date of filing: 19.04.2019
(51) Int. Cl.: C04B 35/119, H01L 23/13, H05K 1/03

(54) **CERAMIC SUBSTRATE AND MOUNTING SUBSTRATE USING SAME, AND ELECTRONIC DEVICE**

(30) Priority: 26.04.2018 JP 2018085379
(71) Applicant: Kyocera Corporation, Kyoto-shi, Kyoto 612-8501 (JP)
(72) Inventor: NISHIMOTO, Kenichi, Kyoto-shi, Kyoto 612-8501 (JP); MIKAKI, Shunji, Kyoto-shi, Kyoto 612-8501 (JP)
(74) Representative: Viering, Jentschura & Partner mbB Patent- und Rechtsanwälte
(86) International application number: PCT/JP2019/016831
(87) International publication number: WO 2019/208438

(57) **Abstract**

A ceramic substrate in the present disclosure contains an alumina crystal particle(s) and a zirconia crystal particle(s). Then, among 100% by mass of all components, alumina is provided at 70% by mass or greater and 95% by mass or less and a total of a stabilizer component(s), hafnia, and zirconia is provided at 5% by mass or greater and 30% by mass or less. Moreover, an average value of an equivalent circle diameter(s) of the alumina crystal particle(s) is greater than an average value of an equivalent circle diameter(s) of the zirconia crystal particle(s) and is 1.2 µm or greater and 1.9 µm or less. Furthermore, a difference between an equivalent circle diameter at a cumulation of 10% (d10) and an equivalent circle diameter at a cumulation of 90% (d90) in a cumulative distribution of an equivalent circle diameter(s) of the alumina crystal particle(s) is 1.5 µm or greater and 2.5 µm or less.

## Description

### Field

The present disclosure relates to a ceramic substrate and a substrate for packaging that uses it, and an electronic device.

### Background

A ceramic substrate has widely been used as a substrate for packaging various types of electronic components such as a semiconductor element, a heat generation element, or a Peltier element, through a metal layer (a substrate for packaging). Then, an alumina substrate that includes zirconia has been known as a ceramic substrate that is used for a substrate for packaging.

For example, Patent Literature 1 (Japanese Patent Application Publication No. 8-195450) discloses a substrate for packaging that is composed of a ceramic substrate that contains alumina and zirconia as main components where one or more kinds of additives that are selected from a group that is composed of yttria, calcia, magnesia, and ceria are added thereto.

### Summary

A ceramic substrate in the present disclosure contains an alumina crystal particle(s) and a zirconia crystal particle(s). Then, among 100% by mass of all components, alumina is provided at 70% by mass or greater and 95% by mass or less and a total of a stabilizer component(s), hafnia, and zirconia is provided at 5% by mass or greater and 30% by mass or less. Moreover, an average value of an equivalent circle diameter(s) of the alumina crystal particle(s) is greater than an average value of an equivalent circle diameter(s) of the zirconia crystal particle(s) and is 1.2 µm or greater and 1.9 µm or less. Furthermore, a difference between an equivalent circle diameter at a cumulation of 10% (d10) and an equivalent circle diameter at a cumulation of 90% (d90) in a cumulative distribution of an equivalent circle diameter(s) of the alumina crystal particle(s) is 1.5 µm or greater and 2.5 µm or less.

Furthermore, a substrate for packaging in the present disclosure includes the ceramic substrate as described above, and a metal layer that is located on the ceramic substrate.

Furthermore, an electronic device in the present disclosure includes the substrate for packaging as described above, and an electronic component that is located on the metal layer of the substrate for packaging. Brief Description of Drawings

FIG. 1 is a plan view that illustrates an example of a substrate for packaging in the present disclosure.
FIG. 2 is a cross-sectional view of a substrate for packaging as illustrated in FIG. 1.
FIG. 3 is a plan view that illustrates an example of an electronic device in the present disclosure.
FIG. 4 is a cross-sectional view of an electronic device as illustrated in FIG. 3.

### Description of Embodiments

In recent years, attainment of a high output of an electronic component progresses, so that an amount of heat that is generated at a time of output of such an electronic component is increased. Accordingly, it is desired that a ceramic substrate that composes a substrate for packaging has an excellent heat release characteristic, that is, a high thermal conductivity.

Furthermore, in recent years, downsizing of an electronic device where an electronic component is packaged on a metal layer of a substrate for packaging progresses. Accordingly, thinning of a ceramic substrate that composes a substrate for packaging is desired, so that a mechanical strength of such a ceramic substrate has to be excellent in order to thin the ceramic substrate. Hence, it is desired that a ceramic substrate has both a high thermal conductivity and a high mechanical strength.

A ceramic substrate in the present disclosure has both a high terminal conductivity and a high mechanical strength. Furthermore, a substrate for packaging that uses a ceramic substrate in the present disclosure as described above allows packaging of an electronic component with a high output. Moreover, a ceramic substrate has a high mechanical strength, so that it is possible to execute thinning thereof and it is possible to withstand use over a long period of time. Moreover, an electronic device in the present disclosure allows use over a long period of time, so that it has high reliability.

Hereinafter, a ceramic substrate and a substrate for packaging that uses it, and an electronic device, in the present disclosure will be explained in detail with reference to the drawings.

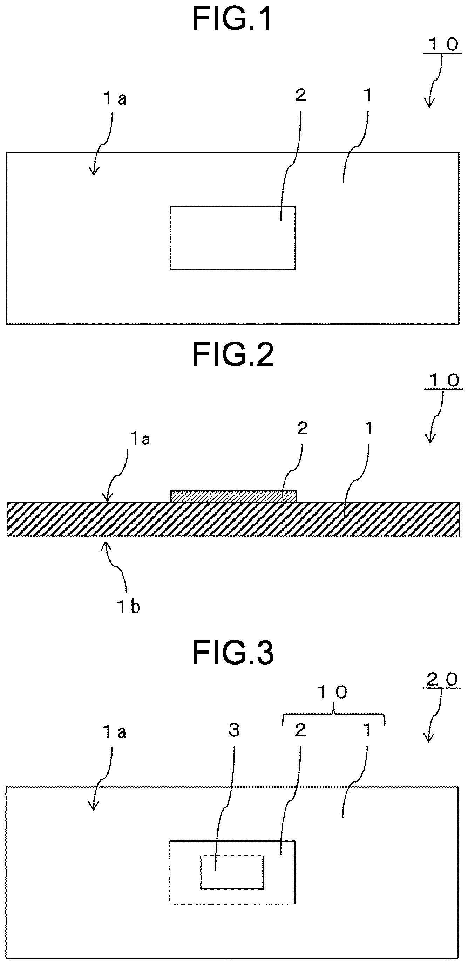

As illustrated in FIG. 1, a substrate for packaging 10 in the present disclosure includes a ceramic substrate 1 in the present disclosure and a metal layer 2. Furthermore, as illustrated in FIG. 2, the ceramic substrate 1 in the present disclosure has a pair of a first surface 1a and a second surface 1b in a thickness direction thereof. In other words, the first surface 1a is located so as to be opposite to the second surface 1b. The second surface 1b is located so as to be opposite to the first surface 1a. Then, the metal later 2 is located on the first surface 1a.

Herein, although FIG. 1 illustrates an example where the metal layer 2 is located on the first surface 1a, it is sufficient that the metal later 2 is located on at least the first surface 1a or the second surface 1b. Furthermore, it may be located on both the first surface 1a and the second surface 1b. Additionally, in a case where the metal layer 2 is located on the second surface 1b in FIG. 1, the metal layer 2 is located below the second surface 1b where such a positional relationship is described as "on a/the second surface 1b".

Then, the ceramic substrate 1 in the present disclosure contains an alumina crystal particle(s) and a zirconia crystal particle(s). Then, among 100% by mass of all components of the ceramic substrate 1, alumina (Al₂O₃) is provided at 70% by mass or greater and 95% by mass or less and a total of a stabilizer component(s), hafnia (HfO₂), and zirconia (ZrO₂) is provided at 5% by mass or greater and 30% by mass or less. Additionally, a stabilizer component(s), hafnia, and zirconia may collectively be described as a zirconia system below.

Alumina is more excellent in a thermal conductivity than zirconia and zirconia is more excellent in a mechanical strength than alumina. A content(s) thereof is/are provided as described above, so that the ceramic substrate 1 in the present disclosure has an excellent thermal conductivity and an excellent mechanical strength.

Moreover, for the ceramic substrate 1 in the present disclosure, an average value of an equivalent circle diameter(s) of an alumina crystal particle(s) is greater than an average value of an equivalent circle diameter(s) of a zirconia crystal particle(s) and such an average value of an equivalent circle diameter(s) of an alumina crystal particle(s) is 1.2 µm or greater and 1.9 µm or less. Furthermore, a difference between an equivalent circle diameter at a cumulation of 10% (d10) and an equivalent circle diameter at a cumulation of 90% (d90) in a cumulative distribution of an equivalent circle diameter(s) of an alumina crystal particle(s) is 1.5 µm or greater and 2.5 µm or less. For a relationship between sizes of crystal particles, in other words, an average value of an equivalent circle diameter(s) of a zirconia crystal particle(s) is less than an average value of an equivalent circle diameter(s) of an alumina crystal particle(s).

Herein, d10 of an alumina crystal particle(s) is a value of an equivalent circle diameter that corresponds to 10% of a total number of an alumina crystal particle(s) when a value(s) of an equivalent circle diameter(s) of an alumina crystal particle(s) is/are arranged in an ascending order and a minimum value of such an equivalent circle diameter(s) is provided as a reference. For example, in a case where the number of alumina crystal particles is 100, d10 of the alumina crystal particles is a value of an equivalent circle diameter that ranks tenth when values of equivalent circle diameters thereof are counted in an ascending order.

Furthermore, d90 of an alumina crystal particle(s) is a value of an equivalent circle diameter that corresponds to 90% of a total number of an alumina crystal particle(s) when a value(s) of an equivalent circle diameter(s) of an alumina crystal particle(s) is/are arranged in an ascending order and a minimum value of such an equivalent circle diameter(s) is provided as a reference. For example, in a case where the number of alumina crystal particles is 100, d90 of the alumina crystal particles is a value of an equivalent circle diameter that ranks ninetieth when values of equivalent circle diameters thereof are counted in an ascending order.

Additionally, an equivalent circle diameter means a diameter of a circle in a case where a surface area of a crystal particle in an observation surface of the ceramic substrate 1 is replaced by a circle with a surface area that is equal thereto.

Then, the ceramic substrate 1 in the present disclosure satisfies such a configuration, so that it has both a high thermal conductivity and a high mechanical strength. Herein, a reason why the ceramic substrate 1 in the present disclosure has both a high thermal conductivity and a high mechanical strength is that, first, contents of alumina and a zirconia system are provided as described above. Second, that is because an average value of an equivalent circle diameter(s) of an alumina crystal particle(s) is within a numerical range as described above and a difference between d10 and d90 of an alumina crystal particle(s) is within a numerical range as described above, so that a crystal particle(s) is/are located densely (is/are compact).

Herein, it is possible to obtain a thermal conductivity by a laser flash method in conformity with JIS R 1611-2010. Additionally, a value of a mechanical strength as illustrated in the present application is a value that is obtained by using a test piece with an elongated plate shape with a width of 10 mm, a thickness of 0.3 mm, and a length of 40 mm and executing a measurement in conformity with JIS R 1601-2008. For having both a high thermal conductivity and a high mechanical strength, specifically, when, among 100% by mass of all components of the ceramic substrate 1, alumina is provided at 90% by mass or less and a zirconia system is provided at 10% by mass, a thermal conductivity is 20 W/m·K or greater and a value of a three-point flexural strength is 600 MPa or greater.

Furthermore, in the ceramic substrate 1 in the present disclosure, an average value of an equivalent circle diameter(s) of a zirconia crystal particle(s) may be 0.4 µm or greater and 0.7 µm or less. The ceramic substrate 1 that satisfies such a configuration has a high thermal conductivity and a high mechanical strength, because each of respective crystal particles is located densely and a zirconia crystal particle that penetrates into a gap between both alumina crystal particles is not readily detached therefrom.

Furthermore, in the ceramic substrate 1 in the present disclosure, a standard deviation of an equivalent circle diameter(s) of a zirconia crystal particle(s) may be 0.38 µm or less. In the ceramic substrate 1 that satisfies such a configuration, sizes of respective zirconia crystal particles are uniform, so that a strength variation thereof is small.

Furthermore, in the ceramic substrate 1 in the present disclosure, a maximum value of an equivalent circle diameter(s) of an alumina crystal particle(s) may be 7 µm or less. In the ceramic substrate 1 that satisfies such a configuration, a strength variation thereof is smaller. Furthermore, a maximum value of an equivalent circle diameter(s) of an alumina crystal particle(s) may be 5 µm or less.

Moreover, in addition to a maximum value of an equivalent circle diameter(s) of an alumina crystal particle(s) that is 7 µm or less, a degree of skewness of a distribution of an equivalent circle diameter(s) of an alumina crystal particle(s) may be greater than 0.5. Herein, when a degree of skewness is a positive value and when a tail on a left side of a top peak in a distribution and a tail on a right side thereof are compared, a tail spreads on a right side (a greater particle diameter), in other words, such a top peak is provided at a less particle diameter. The ceramic substrate 1 that satisfies such a configuration has a higher thermal conductivity and a higher mechanical strength, because each of respective crystal particles is located more densely and a zirconia crystal particle that penetrates into a gap between both alumina crystal particles is not readily detached therefrom. Furthermore, a degree of skewness thereof may be 0.9 or greater.

Furthermore, in the ceramic substrate 1 in the present disclosure, a maximum value of an equivalent circle diameter(s) of a zirconia crystal particle(s) may be 3 µm or less. In the ceramic substrate 1 that satisfies such a configuration, a strength variation thereof is smaller. Furthermore, a maximum value of an equivalent circle diameter(s) of a zirconia crystal particle(s) may be 2 µm or less.

Moreover, in addition to a maximum value of an equivalent circle diameter(s) of a zirconia crystal particle(s) that is 3 µm or less, a degree of skewness of a distribution of an equivalent circle diameter(s) of an alumina crystal particle(s) may be greater than 0.5. The ceramic substrate 1 that satisfies such a configuration has a higher thermal conductivity and a higher mechanical strength, because a zirconia crystal particle fills a gap between both alumina crystal particles so as to decrease such a gap.

Furthermore, in the ceramic substrate 1 in the present disclosure, a proportion of a monoclinic crystal in a zirconia crystal particle(s) may be 2% or greater and 6% or less. When such a configuration is satisfied, generation of a microcrack is suppressed and phase transformation of a zirconia crystal particle(s) is caused, so that it is possible to apply a compressive stress to a surrounding crystal particle(s) by volume expansion at a time of phase transformation into a monoclinic crystal. Furthermore, it is possible to suppress development of a crack that is generated on the ceramic substrate 1 by such a compressive stress. Hence, the ceramic substrate 1 that satisfies a configuration as described above has a higher mechanical strength. Additionally, a proportion of a monoclinic crystal is provided with respect to a total of a tetragonal crystal, a cubic crystal, and a monoclinic crystal.

Next, a component(s) other than alumina and zirconia in the ceramic substrate 1 in the present disclosure will be explained. First, a stabilizer component(s) for zirconia is one kind or two kinds that are selected from among strontia (SrO), yttria (Y₂O₃), ceria (CeO₂), scandia (Sc₂O₃), dysprosia (Dy₂O₃), and the like. In particular, if a stabilizer component is yttria, an ionic radius thereof is close to that of zirconia and hence a degree of stabilization thereof is high, so that a coarse crystal particle(s) of zirconia is/are not readily generated and hence a mechanical strength of the ceramic substrate 1 is improved. Additionally, it is sufficient that a stabilizer component(s) is/are contained within a range of 1 mol% or greater and 12 mol% or less per 100 mol% of zirconia. For example, if a stabilizer component is yttria, it is sufficient that it is contained within a range of 1 mol% or greater and 5 mol% or less per 100 mol% of zirconia.

Furthermore, it is sufficient that hafnia is contained within a range of 1 part by mass or greater and 3 parts by mass or less per 100 parts by mass of zirconia.

Moreover, the ceramic substrate 1 in the present disclosure may contain a sintering aid(s) such as silicon oxide (SiO₂), magnesium oxide (MgO), and/or titanium oxide (TiO₂), as a component(s) other than alumina and a zirconia system, in order to improve a sintering property thereof. Additionally, a sintering aid(s) may be contained within a range of 0.1 part by mass or greater and 2.0 parts by mass or less per 100 parts by mass of a total of alumina and a zirconia system.

Next, an example of various types of measurement methods will be explained.

First, it is sufficient that contents of alumina, a stabilizer component(s), hafnia, zirconia, and a sintering aid(s) are calculated by a following method. First, the ceramic substrate 1 is measured by using an X-ray diffractometer (XRD) and each component that composes the ceramic substrate 1 is confirmed by checking an obtained 2θ (where 2θ is a diffraction angle) against a JCPDS card. Then, qualitative analysis for the ceramic substrate 1 is executed by using an X-ray fluorescence spectrometer (XRF) or an energy dispersive analyzer (EDS) that is attached and provided to a scanning electron microscope (SEM). Then, for an element(s) that is/are detected by such qualitative analysis, quantitative analysis is executed by using an ICP emission spectrophotometer (ICP). Then, it is sufficient that contents of alumina, a stabilizer component(s), hafnia, zirconia, and a sintering aid(s) are calculated from contents of respective elements that are measured by such quantitative analysis, by respectively converting them into oxides thereof.

Then, it is possible to calculate average values of an equivalent circle diameter(s) of an alumina crystal particle(s) and a zirconia crystal particle(s), a difference between d10 and d90 of an alumina crystal particle(s), a standard deviation of an equivalent circle diameter(s) of a zirconia crystal particle(s), maximum values of an equivalent circle diameter(s) of an alumina crystal particle(s) and a zirconia crystal particle(s), and degrees of skewness of distributions of an equivalent circle diameter(s) of an alumina crystal particle(s) and a zirconia crystal particle(s), by a following method.

First, the ceramic substrate 1 is cut and such a cut surface is polished by a cross section polisher (CP) or is processed by using a focused ion beam (FIB) so as to obtain a processed surface. Then, such a processed surface is chemical-etched by hydrofluoric acid or the like or heat-treated at 1400 to 1500 °C so as to obtain an observation surface.

Then, surface analysis of an observation surface is executed by using an electron beam microanalyzer (EPMA). Then, by color mapping of surface analysis, a crystal particle(s) where presence of aluminum is confirmed and oxygen is present at a position of presence of aluminum is/are regarded as an alumina crystal particle(s). Furthermore, a crystal particle(s) where presence of zirconium is confirmed and oxygen is present at a position of presence of zirconium is/are regarded as a zirconia crystal particle(s). Additionally, in a case where a photograph of an observation surface is taken by an SEM, a zirconia crystal particle(s) exhibit(s) a color tone of a white color type whereas an alumina crystal particle(s) exhibit(s) a color tone of a black color type, so that it is possible to identify an alumina crystal particle(s) and a zirconia crystal particle(s) visually.

Then, image data where a photograph of an observation surface is taken by using an SEM are analyzed by using image analysis software (for example, Win ROOF produced by MITANI CORPORATION). Thereby, it is possible to obtain data of equivalent circle diameters of each alumina crystal particle and each zirconia crystal particle that are present in image data.

Then, it is sufficient that average values of an equivalent circle diameter(s) of an alumina crystal particle(s) and a zirconia crystal particle(s), a difference between d10 and d90 of an alumina crystal particle(s), a standard deviation of an equivalent circle diameter(s) of a zirconia crystal particle(s), maximum values of an equivalent circle diameter(s) of an alumina crystal particle(s) and a zirconia crystal particle(s), and degrees of skewness of distributions of an equivalent circle diameter(s) of an alumina crystal particle(s) and a zirconia crystal particle(s) are calculated from such data of an equivalent circle diameter(s).

Furthermore, a measurement for a surface of the ceramic substrate 1 is executed by an XRD, so that it is possible to obtain a proportion of a monoclinic crystal in a zirconia crystal particle(s) from an obtained X-ray diffraction intensity, by a following calculation formula.

A proportion of a monoclinic crystal (%) = (Im1 + Im2) / (Im1 + Im2 + It + Ic)
It: an X-ray diffraction intensity for a (1 1 1) plane of a tetragonal crystal
Ic: an X-ray diffraction intensity for a (1 1 1) plane of a cubic crystal
Im1: an X-ray diffraction intensity for a (1 1 1) plane of a monoclinic crystal
Im2: an X-ray diffraction intensity for a (1 1 -1) plane of a monoclinic crystal

Furthermore, for a thermal conductivity, as a thickness of a test piece is decreased, an obtained value of a thermal conductivity is increased, so that a thermal conductivity of the ceramic substrate 1 in the present disclosure is provided for a test piece with a circular plate shape with a diameter of 10 mm and a thickness of 0.3 mm and is obtained by a laser flash method in conformity with JIS R 1611-2010 after a density thereof is obtained by using such a test piece and an Archimedes' method.

Furthermore, a mechanical strength is provided for a test piece with an elongated plate shape with a width of 10 mm, a thickness of 0.3 mm, and a length of 40 mm, and is obtained by executing a three-point flexural strength test in conformity with JIS R 1601-2008.

Then, as illustrated in FIG. 1 and FIG. 2, the substrate for packaging 10 in the present disclosure includes the ceramic substrate 1 with a configuration as described above and the metal layer 2 that is located on at least the first surface 1a or the second surface 1b of the ceramic substrate 1. A configuration is provided that a thermal conductivity of the ceramic substrate 1 is high and the metal layer 2 is included thereon, so that packaging of an electronic component with a high output is allowed. Moreover, it is possible to execute thinning and it is possible to withstand use over a long period of time, by a high mechanical strength of the ceramic substrate 1. Furthermore, it has a high mechanical strength, so that thinning of the ceramic substrate 1 is also attainable.

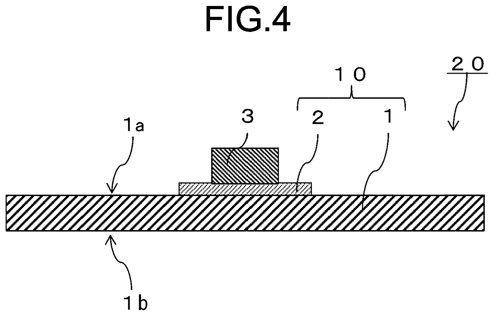

Furthermore, as illustrated in FIG. 3 and FIG. 4, an electronic device 20 in the present disclosure includes the ceramic substrate 1 and an electronic component 3 on the metal layer 2 that is located on the first surface 1a of the ceramic substrate 1. Additionally, a wiring layer that is composed of a metal may be formed in a region other than the metal layer 2 on the first surface 1a of the ceramic substrate 1. Then, the electronic device 20 in the present disclosure satisfies such a configuration, so that it is possible to exert a characteristic that is possessed by the electronic component 3 sufficiently and it is possible to execute use over a long period of time so as to have high reliability.

Herein, it is possible to use the electronic component 3 for, for example, a semiconductor element such as an insulated gate bipolar transistor (IGBT) element, an intelligent power module (IPM) element, a metal-oxide semiconductor field-effect transistor (MOSFET) element, an LED element, a free wheeling diode (FWD) element, a giant transistor (GTR) element, or a Schottky barrier diode (SBD). Furthermore, it is possible to use it for a heat generation element for a sublimation-type thermal printer head or a thermal ink-jet printer head. Moreover, it is possible to use it for a Peltier element.

Next, an example of a manufacturing method for a ceramic substrate in the present disclosure will be explained.

First, an alumina (Al₂O₃) powder, a zirconia (ZrO₂) powder that includes 1 mol% or greater and 5 mol% or less of yttria (Y₂O₃) that is a stabilizer component, and a titanium oxide (TiO₂) powder, a magnesium hydroxide (Mg(OH)₂) powder, and a silicon oxide (SiO₂) powder that are sintering aids are prepared.

Herein, for an alumina powder, three kinds are prepared where equivalent circle diameters at cumulation of 50% (d50) in a cumulative distribution of an equivalent circle diameter(s) of an alumina powder are 0.6 µm, 1.0 µm, and 2.0 µm. Then, predetermined amounts of such three kinds of alumina powders are weighed respectively and are mixed, so as to fabricate a raw material powder A where d50 is 0.75 µm or greater and 1.3 µm or less and a difference between d10 and d90 is 1.7 µm or greater and 1.9 µm or less. Such a raw material powder A is fired on a firing condition(s) as described later, so that it is possible to provide a ceramic substrate where an average value of an equivalent circle diameter(s) of an alumina crystal particle(s) is 1.2 µm or greater and 1.9 µm or less and a difference between d10 and d90 of an alumina crystal particle(s) is 1.5 µm or greater and 2.5 µm or less.

On the other hand, for a zirconia powder, three kinds are prepared where d50 of zirconia powders are 0.2 µm, 0.3 µm, and 0.4 µm. Herein, such a zirconia powder includes, for example, 2 parts by mass of hafnia, per 100 parts by mass of zirconia. Then, predetermined amounts of such three kinds of zirconia powders are weighed respectively and are mixed, so as to fabricate a raw material powder B that has d50 with a value that is less than that of d50 of a raw material powder A.

Additionally, for providing an average value of an equivalent circle diameter(s) of a zirconia crystal particle(s) that is 0.4 µm or greater and 0.7 µm or less and a standard deviation of an equivalent circle diameter(s) of a zirconia crystal particle(s) that is 0.38 µm or less, it is sufficient that a raw material powder B where d50 is 0.3 µm or greater and 0.34 µm or less and a difference between d10 and d90 is 0.75 µm or less is fabricated and it is used.

Furthermore, for weighing for a ceramic substrate, a raw material powder A is weighed in such a manner that alumina is provided at 70% by mass or greater and 95% by mass or less per 100% by mass of all components of such a ceramic substrate, and a raw material powder B is weighed in such a manner that a zirconia system is provided at 5% by mass or greater and 30% by mass or less.

Then, a sintering aid(s) is/are weighed so as to be provided at 0.1 part by mass or greater and 2.0 parts by mass or less per 100 parts by mass of a total of a weighed raw material powder A and raw material powder B.

Then, a raw material powder A, a raw material powder B, and a sintering aid(s), 3 parts by mass or greater and 10 parts by mass or less of an acrylic resin as a binder per 100 parts by mass of a total of the respective powders (the raw material powder A, the raw material powder B, and the sintering aid(s)), and 100 parts by mass of an ion-exchanged water as a solvent are put into and are mixed and agitated in an agitator so as to obtain a slurry.

Then, a sheet is formed by using such a slurry in a doctor blade method. Alternatively, a sheet is formed by using a granule(s) that is/are obtained by spraying and granulating a slurry in a spray granulation device (a spray dryer), in a roll compaction method.

Then, a sheet as described above is processed by mold pressing or laser processing, so as to obtain a molded body with a predetermined product shape.

Then, an obtained molded body is put into a firing furnace under an air (oxidizing) atmosphere (for example, a roller-type tunnel furnace, a batch-type atmosphere furnace, and a pressure-type tunnel furnace) and is held and fired at a maximum temperature of 1475 °C or higher and 1600 °C or lower for 0.5 hours or more and 3 hours or less, so as to obtain a ceramic substrate in the present disclosure.

Additionally, for providing a maximum value of an equivalent circle diameter(s) of an alumina crystal particle(s) that is 7 µm or less, it is sufficient that a maximum temperature for firing is set so as to be lower within a range as described above, and for example, 1510 °C or lower is sufficient. Furthermore, for providing a maximum value of an equivalent circle diameter(s) of a zirconia crystal particle(s) that is 3 µm or less, it is sufficient that a maximum temperature for firing is set so as to be lower within a range as described above, and for example, 1510 °C or lower is sufficient.

Moreover, for providing a maximum value of an equivalent circle diameter(s) of an alumina crystal particle(s) that is 7 µm or less and a degree of skewness of a distribution of an equivalent circle diameter(s) of an alumina crystal particle(s) that is greater than 0.5, it is sufficient that a maximum temperature for firing is provided so as to be lower within a range as described above and a period of time to hold a maximum temperature is set so as to be shorter, and for example, 1510 °C or lower is provided and 1.5 hours or less is provided. Furthermore, for providing a maximum value of an equivalent circle diameter(s) of a zirconia crystal particle(s) that is 3 µm or less and a degree of skewness of a distribution of an equivalent circle diameter(s) of a zirconia crystal particle(s) that is greater than 0.5, it is sufficient that a maximum temperature for firing is provided so as to be lower within a range as described above and a period of time to hold a maximum temperature is set so as to be shorter, and for example, 1510 °C or lower is provided and 1.5 hours or less is provided. Additionally, it is also possible to adjust maximum values of an equivalent circle diameter(s) of an alumina crystal particle(s) and a zirconia crystal particle(s) and/or degrees of skewness of distributions of an equivalent circle diameter(s) of an alumina crystal particle(s) and a zirconia crystal particle(s), by selection of a raw material powder(s).

Furthermore, a surface treatment is applied to a ceramic substrate, so that it is possible to execute adjustment in such a manner that a proportion of a monoclinic crystal in a zirconia crystal particle(s) is 2% or greater and 6% or less. Specifically, a surface treatment is applied to a ceramic substrate, so that phase transformation of a tetragonal crystal or a cubic crystal in a zirconia crystal particle(s) is accelerated and it is possible to increase a proportion of a monoclinic crystal in crystals of zirconia.

Additionally, a specific thickness of a ceramic substrate is 3 mm or less, so that it is possible for a ceramic substrate in the present disclosure to attain a thickness of 0.25 mm as long as such a substrate is used for packaging of an electronic component.

Next, an example of a manufacturing method for a substrate for packaging in the present disclosure will be explained.

First, a ceramic substrate as described above is prepared. Furthermore, a metal paste is prepared that is based on at least one kind of copper, aluminum, or silver and that provides a metal layer. Then, a metal paste is applied to at least a first surface or a second surface of a ceramic substrate by a printing method and is heat-treated so as to form a metal layer. Thus, a metal layer is formed on at least a first surface or a second surface of a ceramic substrate, so as to obtain a substrate for packaging in the present disclosure.

Furthermore, an electronic device in the present disclosure is obtained by packaging an electronic component on a metal layer in a substrate for packaging as described above.

Hereinafter, although practical examples in the present disclosure will be explained specifically, the present disclosure is not limited by such practical examples.

### Practical Example 1

Samples were fabricated where average values of equivalent circle diameters of alumina crystal particles and differences between d10 and d90 of the alumina crystal particles were different, and thermal conductivities and mechanical strengths thereof were measured to execute an evaluation.

First, an alumina powder, a zirconia powder that included 3 mol% of yttria that was a stabilizer component, and a titanium oxide powder, a magnesium hydroxide powder, and a silicon oxide powder that were sintering aids were prepared.

Herein, for the alumina powder, three kinds of alumina powders were prepared where d50 thereof was 0.6 µm, 1.0 µm, and 2.0 µm. Then, predetermined amounts of such three kinds of alumina powders were weighed respectively and were mixed to fabricate a raw material powder A that had d10, d50, and d90 as illustrated in Table 1.

On the other hand, for the zirconia powder, three kinds of zirconia powders were prepared where d50 thereof was 0.2 µm, 0.3 µm, and 0.4 µm. Herein, such zirconia powders included 2 parts by mass of hafnia per 100 parts by mass of zirconia. Then, predetermined amounts of such three kinds of zirconia powders were weighed respectively and were mixed to fabricate a raw material powder B where d10 was 0.14 µm, d50 was 0.32 µm, and d90 was 0.89 µm.

Additionally, for weighing for a ceramic substrate, the raw material powder A was weighed in such a manner that alumina was provided at 90% by mass per 100% by mass of all components of the ceramic substrate and the raw material powder B was weighed in such a manner that a zirconium system was provided at 10% by mass.

Then, the sintering aids were weighed in such a manner that 2 parts by mass thereof was provided per 100 parts by mass of a total of the weighed raw material powder A and raw material powder B. Additionally, the respective powders that were sintering aids were weighed in such a manner that values provided by conversion into SiO₂, TiO₂, and MgO in each sample after firing were at 2.5: 2: 1.

Then, the raw material powder A, the raw material powder B, and the sintering aids, 7 parts by mass of an acrylic resin as a binder per 100 parts by mass of a total of the respective powders (the raw material powder A, the raw material powder B, and the sintering aids), and 100 parts by mass of an ion-exchanged water as a solvent were put into and were mixed and agitated in an agitator to obtain a slurry.

Then, a sheet was formed by using granules that were obtained by spraying and granulating such a slurry in a spray dryer, in a roll compaction method. Then, the sheet as described above was processed by mold pressing to obtain a molded body.

Then, the obtained molded body was put into a firing furnace under air atmosphere and was held and fired at a maximum temperature of 1530 °C for 2 hours to obtain each sample.

Then, an average value of equivalent circle diameters of alumina crystal particles, a difference between d10 and d90 of the alumina crystal particles, and an average value of equivalent circle diameters of zirconia crystal particles in each sample were calculated by a following method.

First, each sample was cut and such a cut surface was polished by a CP to obtain a processed surface. Then, such a processed surface was chemical-etched by a hydrofluoric acid to obtain an observation surface.

Then, image data where a photograph of the observation surface was taken by using an SEM were analyzed by using image analysis software (Win ROOF produced by MITANI CORPORATION). Herein, in the image data, a zirconia crystal particle exhibited a color tone of a white color type whereas an alumina crystal particle exhibited a color tone of a black color type, so that it was possible to identify the alumina crystal particle and the zirconia crystal particle. Then, by such analysis, data of equivalent circle diameters of each alumina crystal particle and each zirconia crystal particle that were present in the image data were obtained.

Then, from such data of equivalent circle diameters, an average value of equivalent circle diameters of alumina crystal particles, a difference between d10 and d90 of the alumina crystal particles, and an average value of equivalent circle diameters of zirconia crystal particles were calculated. As a result, average values of equivalent circle diameters of zirconia crystal particles in all of the respective samples were 0.55 µm.

Furthermore, each of other samples that were fabricated in an identical method was grinding-processed to obtain each of sample A with a diameter of 10 mm and a thickness of 0.3 mm and sample B with a width of 10 mm, a thickness of 0.3 mm, and a length of 40 mm.

Then, a thermal conductivity was obtained by using sample A and a laser flash method in conformity with JIS R1611-2010.

Furthermore, a three-point flexural strength was obtained by using sample B in conformity with JIS R 1601-2008. Results are illustrated in Table 1.

**Table 1**

| Sample No. | Raw material powder A | | | Alumina crystal particles | | | | Thermal conductivity (W/m·K) | Three-point flexural strength (MPa) |
|---|---|---|---|---|---|---|---|---|---|
| | d10 (µm) | d50 (µm) | d90 (µm) | Average value of equivalent circle diameters (µm) | d10 (µm) | d90 (µm) | Difference between d10 and d90 (µm) | | |
| 1 | 0.30 | 0.80 | 1.90 | 1.33 | 0.45 | 1.84 | 1.4 | 21 | 590 |
| 2 | 0.40 | 0.90 | 2.10 | 1.46 | 0.47 | 2.00 | 1.5 | 23 | 660 |
| 3 | 0.45 | 1.00 | 2.20 | 1.62 | 0.53 | 2.62 | 2.1 | 24 | 650 |
| 4 | 0.50 | 1.10 | 2.40 | 1.71 | 0.59 | 3.06 | 2.5 | 24 | 640 |
| 5 | 0.60 | 1.20 | 2.50 | 1.81 | 0.57 | 3.27 | 2.7 | 19 | 630 |
| 6 | 0.35 | 0.70 | 2.10 | 1.05 | 0.51 | 2.14 | 1.6 | 18 | 700 |
| 7 | 0.45 | 0.75 | 2.30 | 1.20 | 0.69 | 2.41 | 1.7 | 20 | 670 |
| 8 | 0.90 | 1.30 | 3.30 | 1.90 | 1.39 | 3.83 | 2.4 | 25 | 620 |
| 9 | 1.00 | 1.45 | 3.70 | 2.03 | 1.62 | 4.24 | 2.6 | 26 | 570 |

From results in Table 1, for sample Nos. 2 to 4, 7, and 8, thermal conductivities were 20 W/m·K or greater and three-point flexural strengths were 600 MPa or greater. Hence, it was found that it had both a high thermal conductivity and a high mechanical strength if an average value of equivalent circle diameters of alumina crystal particles was 1.2 µm or greater and 1.9 µm or less and a difference between d10 and d90 of the alumina crystal particles was 1.5 µm or greater and 2.5 µm or less.

Furthermore, samples of a ceramic substrate were fabricated where contents per 100% by mass of all components of the ceramic substrate were provided as 70% by mass of alumina and 30% by mass of a zirconia system, 80% by mass of alumina and 20% by mass of the zirconia system, and 95% by mass of alumina and 5% by mass of the zirconia system so that average values of equivalent circle diameters of alumina crystal particles and differences between d10 and d90 of alumina crystal particles were different similarly to Practical Example 1 as described above. Then, as thermal conductivities and mechanical strengths were measured and evaluated, it had both a high thermal conductivity and a high mechanical strength if an average value of equivalent circle diameters of alumina crystal particles was 1.2 µm or greater and 1.9 µm or less and a difference between d10 and d90 of the alumina crystal particles was 1.5 µm or greater and 2.5 µm or less. Practical Example 2

Next, samples were fabricated where average values of equivalent circle diameters of zirconia crystal particles and standard deviations of equivalent circle diameters of the zirconia crystal particles were different, and thermal conductivities and mechanical strengths thereof were measured to execute evaluation. Herein, sample Nos. 10 to 16 were fabricated in a method that was identical to that of sample No. 3 in Practical Example 1 except that predetermined amounts of the three kinds of zirconia powders were weighed respectively and were mixed so as to provide a raw material powder B with values in Table 2 in fabrication of each sample. Additionally, sample No. 13 was a sample that was fabricated by a method that was identical to that of sample No. 3 in Practical Example 1.

Then, an average value of equivalent circle diameters of alumina crystal particles, a difference between d10 and d90 of the alumina crystal particles, an average value of equivalent circle diameters of zirconia crystal particles, and a standard deviation of equivalent circle diameters of the zirconia crystal particles, in each sample, were calculated by a method that was identical to a measuring method in Practical Example 1. As a result, average values of equivalent circle diameters of alumina crystal particles and differences between d10 and d90 of the alumina crystal particles, in all of the respective samples, were identical to those of sample No. 3 in Practical Example 1.

Then, measurement of thermal conductivities and three-point flexural strengths was executed by a method that was similar to that of Practical Example 1. Results are illustrated in Table 2.

**Table 2**

| Sample No. | Raw material powder B | | | Zirconia crystal particles | | Thermal conductivity (W/m·K) | Three-point flexural strength (MPa) |
|---|---|---|---|---|---|---|---|
| | d10 (µm) | d50 (µm) | d90 (µm) | Average value of equivalent circle diameters (µm) | Standard deviation of equivalent circle diameters (µm) | | |
| 10 | 0.10 | 0.28 | 0.65 | 0.34 | 0.28 | 21 | 680 |
| 11 | 0.11 | 0.30 | 0.70 | 0.40 | 0.29 | 22 | 670 |
| 12 | 0.16 | 0.32 | 0.73 | 0.55 | 0.28 | 25 | 660 |
| 13 | 0.14 | 0.32 | 0.89 | 0.55 | 0.38 | 24 | 650 |
| 14 | 0.12 | 0.32 | 0.91 | 0.55 | 0.40 | 23 | 620 |
| 15 | 0.18 | 0.34 | 0.95 | 0.70 | 0.42 | 25 | 610 |
| 16 | 0.25 | 0.38 | 1.02 | 0.76 | 0.44 | 26 | 600 |

From results in Table 2, for sample Nos.11 to 15, thermal conductivities were 22 W/m·K or greater and three-point flexural strengths were 610 MPa or greater. Hence, it was found that it had both a higher thermal conductivity and a high mechanical strength if an average value of equivalent circle diameters of zirconia crystal particles was 0.4 µm or greater and 0.7 µm or less.

Furthermore, for sample Nos. 11 to 13 among sample Nos. 11 to 15, three-point flexural strengths were 650 MPa or greater. Hence, it was found that a mechanical strength was further improved if a standard deviation of equivalent circle diameters of zirconia crystal particles was 0.38 µm or less.

### Practical Example 3

A sample was fabricated where a firing condition was different from that of sample No. 8 in Practical Example 1 and comparison of three-point flexural strengths was executed. As described in Practical Example 1, sample No. 8 was fabricated by holding a maximum temperature of 1530 °C for 2 hours. A sample where a firing condition was different from that of sample No. 8 was identical to sample No. 8 before firing and fabricated on a firing condition where a maximum temperature was provided at 1510 °C and held for 1.5 hours (sample No. 17).

Additionally, while a sample size was a width of 10 mm, a thickness of 0.3 mm, and a length of 40 mm, five pieces each were fabricated, and three-point flexural strengths were measured in conformity with JIS R 1601-2008. As a result, a strength variation of sample No. 17 was less than that of sample No. 8.

For sample No. 8, a maximum value of equivalent circle diameters of alumina crystal particles was greater than 7 µm. On the other hand, for sample No. 17, a maximum value of equivalent circle diameters of alumina crystal particles was not greater than 7 µm.

From such results, it was found that a strength variation was decreased as a maximum value of equivalent circle diameters of alumina crystal particles was 7 µm or less.

### Practical Example 4

For sample No. 8 and sample No. 17, test pieces with a width of 10 mm, a thickness of 0.3 mm, and a length of 40 mm were fabricated and thermal conductivities were obtained by a laser flash method in conformity with JIS R1611-2010. As a result, a thermal conductivity of sample No. 17 was greater than that of sample No. 8. Furthermore, for confirmation of a strength variation in Practical Example 3, a value of a three-point flexural strength of sample No. 17 was greater than that of sample No. 8.

For sample No. 8, a degree of skewness of a distribution of equivalent circle diameters of alumina crystal particles was less than 0.5. On the other hand, for sample No. 17, a degree of skewness of a distribution of equivalent circle diameters of alumina crystal particles was greater than 0.5.

From such results, it was found that it had a higher thermal conductivity and a high mechanical strength as a maximum value of equivalent circle diameters of alumina crystal particles was 7 µm or less and a degree of skewness of a distribution of equivalent circle diameters of the alumina crystal particles was greater than 0.5. Practical Example 5

A sample was fabricated where a firing condition was different from that of sample No. 16 in Practical Example 2 and comparison of three-point flexural strengths was executed. Sample No. 16 was fabricated by holding a maximum temperature of 1530 °C for 2 hours. A sample where a firing condition was different from that of sample No. 16 was identical to sample No. 16 before firing and fabricated on a firing condition where a maximum temperature was provided at 1510 °C and held for 1.5 hours (sample No. 18).

Additionally, while a sample size was a width of 10 mm, a thickness of 0.3 mm, and a length of 40 mm, five pieces each were fabricated, and three-point flexural strengths were measured in conformity with JIS R 1601-2008. As a result, a strength variation of sample No. 18 was less than that of sample No. 16.

For sample No. 16, a maximum value of equivalent circle diameters of zirconia crystal particles was greater than 3 µm. On the other hand, for sample No. 18, a maximum value of equivalent circle diameters of zirconia crystal particles was not greater than 3 µm.

From such results, it was found that a strength variation was decreased as a maximum value of equivalent circle diameters of zirconia crystal particles was 3 µm or less.

### Practical Example 6

For sample No. 16 and sample No. 18, test pieces with a width of 10 mm, a thickness of 0.3 mm, and a length of 40 mm were fabricated and thermal conductivities were obtained by a laser flash method in conformity with JIS R1611-2010. As a result, a thermal conductivity of sample No. 18 was greater than that of sample No. 16. Furthermore, for confirmation of a strength variation in Practical Example 5, a value of a three-point flexural strength of sample No. 18 was greater than that of sample No. 16.

For sample No. 16, a degree of skewness of a distribution of equivalent circle diameters of zirconia crystal particles was less than 0.5. On the other hand, for sample No. 18, a degree of skewness of a distribution of equivalent circle diameters of zirconia crystal particles was greater than 0.5.

From such results, it was found that it had a higher thermal conductivity and a high mechanical strength as a maximum value of equivalent circle diameters of zirconia crystal particles was 3 µm or less and a degree of skewness of a distribution of equivalent circle diameters of alumina crystal particles was greater than 0.5. Reference Signs List
- 1:: ceramic substrate
- 1a:: first surface
- 1b:: second surface
- 2:: metal layer
- 3:: electronic component
- 10:: substrate for packaging
- 20:: electronic device

## Claims

1. A ceramic substrate that contains an alumina crystal particle(s) and a zirconia crystal particle(s), wherein,
among 100% by mass of all components, alumina is provided at 70% by mass or greater and 95% by mass or less and a total of a stabilizer component(s), hafnia, and zirconia is provided at 5% by mass or greater and 30% by mass or less,
an average value of an equivalent circle diameter(s) of the alumina crystal particle(s) is greater than an average value of an equivalent circle diameter(s) of the zirconia crystal particle(s) and is 1.2 µm or greater and 1.9 µm or less, and
a difference between an equivalent circle diameter at a cumulation of 10% (d10) and an equivalent circle diameter at a cumulation of 90% (d90) in a cumulative distribution of an equivalent circle diameter(s) of the alumina crystal particle(s) is 1.5 µm or greater and 2.5 µm or less.

2. The ceramic substrate according to claim 1, wherein
an average value of an equivalent circle diameter(s) of the zirconia crystal particle(s) is 0.4 µm or greater and 0.7 µm or less.

3. The ceramic substrate according to claim 1 or claim 2, wherein
a standard deviation of an equivalent circle diameter(s) of the zirconia crystal particle(s) is 0.38 µm or less.

4. The ceramic substrate according to any one of claim 1 to claim 3, wherein
a maximum value of an equivalent circle diameter(s) of the alumina crystal particle(s) is 7 µm or less.

5. The ceramic substrate according to claim 4, wherein
a degree of skewness of a distribution of an equivalent circle diameter(s) of the alumina crystal particle(s) is greater than 0.5.

6. The ceramic substrate according to any one of claim 1 to claim 5, wherein
a maximum value of an equivalent circle diameter(s) of the zirconia crystal particle(s) is 3 µm or less.

7. The ceramic substrate according to claim 6, wherein
a degree of skewness of a distribution of an equivalent circle diameter(s) of the zirconia crystal particle(s) is greater than 0.5.

8. A substrate for packaging, comprising:
the ceramic substrate according to any one of claim 1 to claim 7; and
a metal layer that is located on the ceramic substrate.

9. An electronic device, comprising:
the substrate for packaging according to claim 8; and
an electronic component that is located on the metal layer of the substrate for packaging.
